# EUROPEAN PATENT APPLICATION

(11) **EP 4 354 666 A1**
(43) Date of publication of application: **17.04.2024**
(21) Application number: 22200612.4
(22) Date of filing: 10.10.2022
(51) Int. Cl.: H01R 9/24, H01R 9/26, H02B 1/052

(54) **SYSTEM FOR CONNECTING TWO CONTROLLER SYSTEM MODULES**

(71) Applicant: Danfoss A/S, 6430 Nordborg (DK)
(72) Inventor: Hahs, Charles, 6430 Nordborg (DK); De Bona, Rossano, 6430 Nordborg (DK)
(74) Representative: Keil & Schaafhausen Patentanwälte PartGmbB

(57) **Abstract**

The invention relates to a system for electrically connecting two controller system modules (1) that are mounted side by side on a rail for holding controller system modules.

The objective of the invention is to provide a system for connecting controller system modules (1) that is cost-effective, space-saving, and allows easy installation..

This objective is solved by a system comprising a connector (3) comprising a connector housing, which is connectable to mounting portions (8,12) of the two controller system modules (1), thereby connecting the controller system modules electrically and mechanically.

## Description

The present invention relates to a system for electrically connecting two controller system modules, e.g. automation controller system modules, that are mounted side by side on a rail for holding controller system modules.

Further, the present invention relates to a corresponding method.

Automation controller systems often include several individual controller system modules that are mounted together on a rail, e.g. on a wall or in a controller cabinet. The rail is, for example, a standardized equipment rail. Typically, the rail is attached to extend in a horizontal manner and several controller system modules are arranged next to each other on the rail. As an example, such rails are defined in DIN EN 60715. Usually, each controller system module comprises a mounting fixture for mounting the individual controller system module on the rail. Furthermore, multiple rails can be arranged in rows vertically distanced to each other.

According to one aspect, the rail may have a flat shape. The rail may be profiled strip, for example. The rail may have a (longitudinal) direction, that typically extends horizontally if the rail is installed. If the rail has a flat shape, one might also refer to a plane of the rail, which is a plane along which the flat shape extends. If referring to the (longitudinal) direction or the plane of the rails, this may be considered for the case that the modules are mounted to the rails as intended.

The modules can comprise cable terminals e.g. for connecting ethernet cables, bus cables, other data cables, power cables, and/or alike. Typically, components like actuators and/or sensors can be connected to the at least some of the controller system modules.

Typically, the controller system modules have to be connected for allowing data exchange between them, e.g. via network cables or bus cables. This allows the different controller system modules to work together as part of the automation controller system. Further, it is possible that at least some of the controller system modules have to be connected by power cables for providing electrical power between them.

With increasing complexity of the automation controller system, this becomes more difficult. Firstly, the cables for connecting different controller system modules require space but the room in the control cabinets is often limited. Secondly, some control cabinets are ventilated, and additional cables can impair the circulation. Thirdly, properly assignment and connection of individual cables to the specific controller system modules gets more difficult and prone to mistakes with increasing complexity of the automation controller system. The correct installation and wiring becomes complex and time intensive. Furthermore, cables are cost intensive. Finally, all cable terminals of the controller system modules are typically located at upper surfaces and bottom surfaces of the controller system modules only in order to allow a small depth of installation (e.g. within the cabinet). As a consequence, the space on the individual controller system module that is available for cable terminals is very limited. Nevertheless, the cable terminals needed for allowing data transfer between the controller system modules requires a part of this limited space. Connecting controller system modules via cables with each other hence reduces the available space for other cable connections, e.g. input/output ports (I/O ports) for sensors, actuators, and the like.

Therefore, the underlying problem of the invention is to provide a system for connecting controller system modules that is cost-effective, space-saving, and allows easy installation.

This problem is solved by a system for connecting two controller system modules according to claim 1. Preferred embodiments are described in the dependent claims.

The system includes a connector having a connector housing, wherein a first module of the two controller system modules comprises, at an end portion of the first module facing a second module of the two controller system modules, a first mounting portion for receiving a first portion of the connector housing, wherein the second module comprises, on an end portion of the second module facing the first module, a second mounting portion for receiving a second portion of the connector housing,
wherein the system comprises an engagement mechanism for releasably mechanically fixing the connector to the first module and to the second module when the first portion is received in the first mounting portion and the second portion is received in the second mounting portion, and
wherein the system includes electrical connection mechanism for electrically connecting the first module with the second module via the connector when the connector is inserted in the first mounting portion and the second mounting portion.

The controller system modules, also referred to as "modules" in the following, are mounted on the rail for holding controller system modules. They are mounted side by side on the rail, i.e. next to each other on the same rail.

The rail may be a standardized equipment mounting rail, e.g. according to DIN EN 60715, or the like.

The controller system modules (the modules) may be automation controller system modules. They may be configured to form part of an automation controller system. In particular, they may be automation controller system modules for an automation controller system for controlling climate systems, parts thereof (including air condition systems and/or refrigeration systems), and/or industrial installations, for example production facilities.

As an example, the controller system may be configured to control components like actuators, compressors, valves, fans, robots, and alike, e.g. within an automated system. The modules may be configured accordingly.

According to one aspect, the term "controller system module" may encompass e.g. electronic controller modules, power supply modules, input-output modules (I/O modules), and alike.

In one embodiment, at least one of the modules (e.g. at least one of the first module and the second module) can be connected to at least one sensor, e.g. to a temperature sensor, a fluid flow sensor, a humidity sensor, and/or a dew point sensor. The controller system, especially the first module and/or the second module, may be configured to provide control signals for controlling operational components (e.g. actuators, valves, fans, compressors, heat exchangers, fluid flow mixers, and the like) based on information received from the sensor(s). The at least one module and/or the other one of the first module and the second module may be configured to be connected to such operational components.

A respective module may include one or more electric and/or electronic components, e.g. a circuit board, a processor, a memory, a speaker, a power supply means (for example, a battery), or alike.

According to one aspect, at least one of the first module and the second module may comprise a network connector as a cable terminal, e.g. an ethernet connector and/or a bus connector.

Each of the two controller system modules, which are mounted adjacent to each other on the rail, comprises a mounting portion (for receiving the connector), wherein the first module comprises a first mounting portion, and the second module comprises a second mounting portion. The first and second mounting portions are arranged on respective end portions of the modules facing each other. Especially, the first mounting portion and the second mounting portions are arranged next to each other (when the modules are mounted side by side on the rail), forming a common receiving portion for the connector, respectively the connector housing. The connector housing (and hence the connector) can be placed in a detachable manner in the receiving portion formed by the first mounting portion (of the first module) and the second mounting portion (of the second module).

According to a further aspect, the engagement mechanism may be configured to guide the connector housing into a predetermined final position. In more detail, at least one of the first mounting portion and the second mounting portion, preferably both of them, are configured to guide the connector housing into the predetermined final position. The connector housing can comprise geometric elements, which correspond to a guidance of the mounting portions. Such a guidance can include, for example, a protrusion which interacts with a groove of the connector housing and/or the other way around. The engagement mechanism may comprise a projection and pinhole mechanism, for example. In one embodiment, the first mounting portion and the second mounting portion include at least one pinhole, respectively, for receiving a corresponding projection (a corresponding "lance projection") of the connector (in more detail of the connector housing).

Once mounted, the connector housing is retained by the engagement mechanism in a detachable manner, such that the connector housing can be removed easily. This allows an easy amendment of the module layout and results in a good flexibility.

In one embodiment, the engagement mechanism includes a snap connection. The snap connection is an easy to assemble connection. An element of the snap connection can be bent in a predetermined way, such that this element can snap in an indentation or alike, in an assembled state. When the element is transferred in its bent state, the engagement mechanism is disengaged, and the connector housing can be removed. In one embodiment, the snap connection is configured such that it can be handled toolless.

In one embodiment, the snap connection comprises a resilient snap-in member on the connector housing, for example a resilient tongue. Providing the resilient snap-in member on the connector housing results in an easy production process of the snap connection. Especially, the snap-in member may be formed integrally with (a part of) the connector housing. Furthermore, in case of failure of the resilient member, the connector housing can be replaced easily and cost effective.

In one embodiment, the first module and the second module include catch features for catching the snap-in member when the first portion is received in the first mounting portion and the second portion is received in the second mounting portion. The catch feature can be formed as a hole or an indentation, for example. The catch feature can be placed such that the snap-in member of the connector housing can interact with the catch feature when the connector housing is placed in the receiving portion in the predetermined position. This allows a detachable connection, which is easy to install and to remove.

In one embodiment, the first mounting portion and the second mounting portion are mirror-symmetric to each other, wherein the connector housing exhibits a corresponding mirror-symmetry with regard to a central plane. Especially, the first portion and the second portion of the connector housing may be mirror-symmetric to the central plane. The mirror-symmetry allows that the first and second mounting portions can be formed mirror-symmetric as well. In particular, the first mounting portion and the second mounting portion may be mirror-symmetric to each other with regard abutment plane, at which the first module and the second module face and/or abut each other when they are mounted side by side on the rail. The abutment plane may be (at least) substantially perpendicular to the rail.

In an installed state of the connector housing in the receiving portion, the central plane is arranged right between the first module and the second module. This results in low production costs of module housings and the connector housings. In particular, the system might be configured such that the central plane (of the connector housing) coincide with the abutment plane in the installed state, i.e. when the connector housing (and hence the connector) is in the predetermined final position.

The system (especially the at least one of the first mounting portion and the second mounting portion and the connector housing) may be configured to exhibit a mechanical poka-yoke functionality ensuring that the connector can be installed to the first module and second module only in one single predetermined final position and spatial orientation. By this, it can be ensured that the electrical connection mechanism only connects predetermined contacts of the first module and the second module. This applies even if the contacts and/or the respective functionalities are arranged in a non-symmetric manner in the respective module.

In one embodiment, at least one of the first mounting portion and the second mounting portion is asymmetric with regard to a plane that is perpendicular to the abutment plane parallel to a longitudinal direction of the rail (when the first and second modules are mounted on the rail) such that the connector can be inserted to the at least one of the first mounting portion and the second mounting portion along the insertion direction only with one spatial orientation. Additionally or alternatively, a portion of the connector (especially a portion of the connector housing) that is configured to be received in the receiving portion is asymmetric regarding a plane that is perpendicular to the central plane and parallel to the insertion direction. The connector housing can be inserted into the receiving portion only in one specific alignment. As a result, the engagement mechanism would not work if the connector housing was inserted in a wrong manner, such that the connector housing can be installed only in a correct manner. Especially, the at least one of the first mounting portion and the second mounting portion can be asymmetric with regard to a plane that is (at least substantially) perpendicular to the abutment plane and/or perpendicular to the insertion direction.

The insertion direction may be parallel to the abutment plane. The insertion direction may be (at least substantially) perpendicular to the rail (if mounted). The system may be configured such that the connector must be inserted from a top side of the (adjacent) first and second modules towards the rail along the insertion direction, wherein the top side is facing away from the rail.

The electrical connection mechanism is adapted to (automatically) establish a data connection and/or power connection between the first module and the second module if the connecter is installed between the first module and the second module (when they are arranged side by side on the rail). In other words, the electrical connection mechanism is adapted to connect the first module and the second module electronically in a signal, information and/or power transferring manner (when the connector is attached to the first module and the second module arranged side by side). This allows that the two modules, the first module and the second module, can communicate and/or exchange power. Thus, no additional cable connection is required. This system is cost effective. Further, none of the cable terminals of the modules are blocked for connecting the two adjacent modules. The cable terminals can be used for connecting external devices, e.g. sensors, actuators, compressors, robots, and/or alike. Thus, there is a good flexibility for connecting a high number of external devices with the automation controller system, especially with the first module and/or the second module. The cable terminals which would be needed for connecting the two modules otherwise may be even replaced by different cable terminals, i.e. I/O connectors for connecting external devices like sensors and/or operational components.

According to a further aspect, the electrical connection mechanism comprises a (first) electrical interconnection terminal at the first module and a (second) electrical interconnection terminal at the second module, wherein the connector comprises an electrically conducting assembly for connecting the first interconnection terminal with the second interconnection terminal (when the connector is installed in the first module and the second module, i.e. when the connector is attached to both modules in the predetermined final position).

In a preferred embodiment, the electrical connection mechanism comprises a (first) female head pin socket at the first module (as the electrical interconnection terminal at the first module) and a (second) female head pin socket at the second module (as the electrical interconnection terminal at the second module), wherein the connector comprises a U-shaped pin assembly for connecting the first female head pin socket with the second female head pin socket. The pin assembly connects the female head pin socket of one module with the female head pin socket of the other module, creating at least one electrical connection between the two modules. In this embodiment, the pin assembly constitutes the electrically conducting assembly of the connector. This assembly is easy to mount and dismantle.

The pin assembly might comprise, for example, four to twenty pins. Each of the female head pin sockets may include a corresponding number of pin mounts.

In one embodiment, the connector is configured to allow limited movement of the U-shaped pin assembly relative to the connector housing. Therefore, tolerances of any kind of the connector and/or a positioning of the head pin sockets can be compensated allowing a reliable connection between the first and the second module. The movement allows an easy assembly of the connector even, if the head pin sockets of the first and/or second module are not aligned correctly. Hence, the assembly of the connector is easy.

The electrical connection mechanism can be configured to establish a number of individual electrical connections between the first and second module via the connector (for example, via the pin assembly) when the connector is inserted in the first mounting portion and the second mounting portion (i.e. when the connector is installed in the predetermined final position between the modules). The number may be at least two, for example at least four. Additionally or alternatively, the number may be twenty-four at the maximum, for example twelve at the maximum. Some of the individual electrical connections, for example at least two, can be configured for a data bus and/or network connection between the modules. Additionally or alternatively, some of the individual electrical connections can be configured for electrical power transfer between the modules. Hence, one of the modules can supply electrical power for operation to the other module. According to a further aspect, some of the electrical connections can be configured for separate communication of specific electrical signals, e.g. electrical signals relating to a stepper motor control.

In a preferred embodiment, the system is configured such that the connector is inserted into the first and second mounting portion substantially simultaneously, such that an assembly process is easy to handle. Substantially may mean that the connector is connected to the first mounting portion and the second mounting portion within one single movement.

According to a further aspect, the second module may comprise the second engagement portion and a (further) first engagement portion. Additionally or alternatively, the first module may comprise both the first engagement portion and a further second engagement portion. By this, a plurality of modules can be connected with each other in series by a corresponding number of connectors (a number of controller modules minus one). Accordingly, the system may comprise at least three controller system modules and at least two connectors.

In one embodiment, the system comprises an end connector for the first mounting portion (referred to as "right end connector"). The right end connector is configured to be received in the first mounting portion. The right end connector may comprise a cable connector assembly for connecting at least one cable thereto. The right end connector can be configured for electrically connecting the corresponding controller system module with its cable connector assembly when the right end connector is inserted in the first mounting portion. The right end connector may comprise a pin assembly configured to engage the first female head pin socket (when inserted in the first mounting portion). The right end connector may comprise mechanical corresponding to the parts of the engagement mechanism on the connector for engagement with the first mounting portion. A housing of the right end connector may be substantially the same as the connector housing of the connector. For example, a portion corresponding to at least 60 % of the mass of the housing of the right end connector may be identical with the connector housing of the connector.

Additionally or alternatively, the system comprises an end connector for the second mounting portion (referred to as "left end connector"). The left end connector is configured to be received in the second mounting portion. The right end connector may comprise a pin assembly configured to engage the second female head pin socket (when inserted in the second mounting portion). The left end connector may comprise a cable connector assembly for connecting at least one cable thereto. The left end connector can be configured for electrically connecting the corresponding controller system module with its cable connector assembly when the left end connector is inserted in the second mounting portion. The left end connector may comprise mechanical corresponding to the parts of the engagement mechanism on the connector for engagement with the second mounting portion. A housing of the left end connector may be substantially the same as the connector housing of the connector. For example, a portion corresponding to at least 60 % of the mass of the housing of the left end connector may be identical with the connector housing of the connector.

Furthermore, the above problem is solved by a method according to claim 9. Preferred embodiments are disclosed in the dependent claims.

The method includes using the system according to any one of the embodiments described elsewhere. The modifications and advantages described with regard to the system apply to the method accordingly, and vice versa

The connector housing is inserted into the first mounting portion of the first module and into the second mounting portion of the second mounting portion, such that the modules are connected electronically via the electrical connection mechanism to each other. Thus, the modules are connected to each other by placing only one connector housing in both mounting portions. This is easy, cost effective, and less prone to errors.

In one embodiment, the connector housing is inserted substantially simultaneous into the first and second mounting portions. The connector housing is inserted into the first and second mounting portions within one single movement, such that the assembly process is short.

In one embodiment, the connector is installed single handed. By mounting the connector using only one hand, the other hand is free. Therefore, a person, installing the connector, can hold on to something else, or even hold a second connector to connect two modules in a subsequent step. This is time effective and thus cost effective.

In one embodiment, the connector is inserted along the insertion direction, which is a direction perpendicular to the rail from the top side of the controller system module towards the rail, wherein the top side is facing away from the rail. Rails can be arranged in multiple rows vertical distanced to each other, such that between each row is only limited space. Thus, the connector can be inserted easily from the top side towards the rail.

The problem mentioned above is further solved by a controller system module, e.g. an automation controller system module, for a system according to any one of the embodiments described above.

The controller system module comprises at least one of the first mounting portion and the second mounting portion and a corresponding electrical interconnection terminal for connection with an electrically conducting assembly of the connector when the connector is mounted to the controller system module.

The electrical interconnection terminal may be a pin connector assembly, for example a female head pin socket.

In one embodiment, the controller system module comprises
- one first mounting section (configured for forming part of a first receiving portion and for mounting the right end connector) and a corresponding first electrical interconnection terminal (e.g. a first female head pin socket) and
- one second mounting portion (configured for forming part of a second receiving portion and for mounting the left end connector) and a corresponding second electrical interconnection terminal (e.g. a second female head pin socket).

According to one aspect, the controller system module may comprise the catch feature(s) for catching the snap-in member of the connector when the first portion of the connector is received in the first mounting portion.

Additionally or alternatively, the controller system module may comprise the catch feature(s) for catching the snap-in member of the connector when the first portion of the connector is received in the second mounting portion.

In one embodiment, the controller system module is for a system with at least the features according to claim 4 and according to claim 7, wherein the controller system module includes at least one of the catch features and at least one female head pin socket.

The problem mentioned above is further solved by a connector for a system according to any one of the embodiments described above, wherein the first electrical interconnection terminal is formed at the first module and the second electrical interconnection terminal is formed at the second module.

The connector comprises an electrically conducting assembly for connecting the first electrical interconnection terminal with the second electrical interconnection terminal when the connector is mounted to the first module and the second module.

The electrically conducting assembly of the connector may be the U-shaped pin assembly.

In one embodiment, the connector comprises the connector housing and the resilient snap-in member on the connector housing.

According to another aspect, the connector may include one of, several of, or all of the following features described elsewhere:
- a protrusion guidance for the first mounting portion,
- a tongue and groove section for the first mounting portion,
- a locking feature for the first guiding portion,
- the lance protrusion for the first guiding portion,
- a protrusion guidance for the second mounting portion,
- a tongue and groove section for the second mounting portion,
- a locking feature for the second mounting portion,
- the lance protrusion for the second guiding portion
- two protection plates for protecting the electrically conducting assembly, and
- an actuatable top section.

In one embodiment, the connector is for a system with at least the features according to claim 3 and according to claim 7, wherein the connector includes the resilient snap-in member and the U-shaped pin assembly.

The above problem is further solved by an end connector for a system according to any one of the embodiments described above, wherein, at least at one of the first mounting portion and the second mounting portion, an electrical interconnection terminal is formed on the corresponding controller system module,
wherein the end connector is adapted to be releasably mounted to the one of the first mounting portion and the second mounting portion,
wherein the end connector comprises a cable connector assembly for connecting at least one cable thereto and an electrically conducting assembly for connecting the electrical interconnection terminal at the one of the first mounting portion and the second mounting portion with the cable connector assembly when the end connector is mounted to the one of the first mounting portion and the second mounting portion.

The end connector may be the right end connector or the left end connector as described elsewhere.

The electrically conducting assembly may comprise end pins for contacting the electrical interconnection terminal at the one of the first mounting portion and the second mounting portion.

In one embodiment, the end connector comprises the connector housing and the resilient snap-in member on the connector housing.

According to another aspect, the end connector may include one of, several of, or all of the following features described elsewhere:
- a protrusion guidance for the first mounting portion,
- a tongue and groove section for the first mounting portion,
- a locking feature for the first guiding portion,
- the lance protrusion for the first guiding portion,
- a protrusion guidance for the second mounting portion,
- a tongue and groove section for the second mounting portion,
- a locking feature for the second mounting portion,
- the lance protrusion for the second guiding portion
- two protection plates for the electrically conducting assembly, and
- an actuatable top section.

The embodiments, modifications, and corresponding advantages described with regard to the system, the controller system module, the connector, the end connector, and the method apply mutatis mutandis with regard to each other, respectively.

In the following, the invention is described with reference to a preferred embodiment. Herein showing:
- Fig. 1: A perspective view of several controller system modules of a controller system that are mounted on a rail;
- Fig. 2: a perspective view of a controller system module having an end connector connected to a mounting portion of the controller system module;
- Fig. 3: a perspective view of a controller system module;
- Fig. 4: a schematic top view onto the controller system module of Fig. 3;
- Fig. 5: a detailed perspective view of the mounting portion of a controller system module depicted in Fig. 3;
- Fig. 6: a perspective view of a middle connector for electrically and mechanically connecting two controller system modules installed side by side on a rail;
- Fig. 7: a schematic view of a side of the middle connector shown in Fig. 6;
- Fig. 8: a perspective view of the end connector;
- Fig. 9: a perspective view of a first side of the end connector of Fig. 8;
- Fig. 10: a schematic view of a top side of the end connector of Fig. 8;
- Fig. 11: a schematic sectional view of connected controller system modules and connectors.

Identical elements are referred to with the same reference signs.

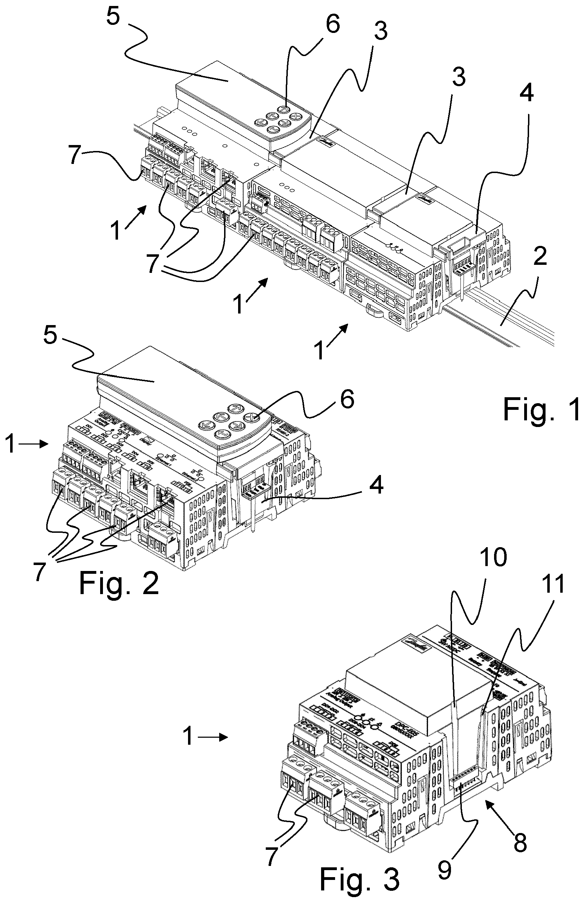

Fig. 1 shows multiple controller system modules 1 of a controller system that are mounted on a rail 2. The rail 2 is a standardized equipment rail, e.g. a DIN rail or alike. Adjacent controller system modules 1 are mechanically and electrically connected by a middle connector 3, respectively. The rail 2 is usually mounted on a wall (not depicted) and/or in a controller cabinet, wherein multiple rails 2 can be mounted vertically distanced to each other forming rows. The controller system modules 1 of the same row are connectable to the adjacent ones using the middle connectors 3, while the far right or far left controller system modules 1 of each row are connectable across rows via end connectors 4.

The terms "connector" and "connector housing" can be used synonymously in the following. "Controller housing" and "controller system module" can be used synonymously in the following as well.

One of the controller system modules 1 has a top unit 5 mounted, which can be used to control, service, or maintain settings of the controller system modules 1. The top unit 5 comprises a display (not depicted) and a user input device having multiple buttons 6, through which a service person can interact with the controller system module 1.

The controller system module 1 comprises multiple external connectors 7. The external connectors include, for example, cable connection clamps and RJ-45 jackets. The external connectors 7 are arranged on sides of the controller system module 1 opposing each other.

The controller system module 1 can be an electronic controller module, an I/O-module and/or a power supply module, wherein the controller system modules 1 can control external components like actuators, compressors or alike, which are not depicted. Further, one or more of the controller system modules 1 can be connected to sensors (not depicted). Based on information provided by the sensors, the controller system modules 1 are able to determine control information for controlling the external components.

Fig. 2 depicts the controller system module 1 with the top unit 5 being mounted on a top side of the controller system module 1. The controller system module 1 comprises several cable terminals 7, including two ethernet ports (e.g. RJ-45 jacks or GG-45 jacks). Further, the controller system module 1 depicted in Fig. 2 is connected to the end connector 4.

Fig. 3 shows a controller system module 1 having multiple cable terminals 7 and a first mounting portion 8. The first mounting portion 8 comprises a female head pin socket 9, a catch feature to catch a snap-in member of the connector 3, 4, and guidance members, wherein the guidance members include a protrusion guidance 10 as well as a tongue and groove section 11.

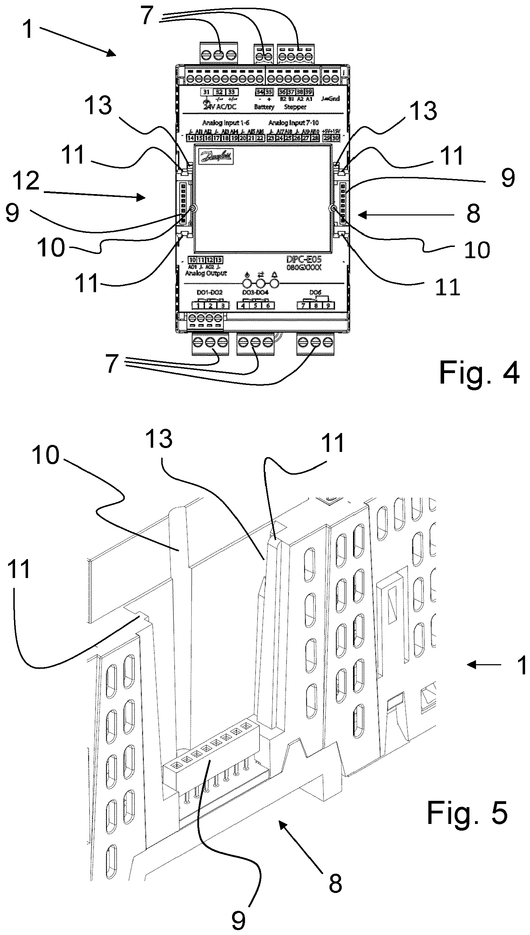

Fig. 4 depicts a top view of the controller system module 1 which comprises the first mounting portion 8 (on the left side in Fig. 4) and a second mounting portion 12 (on the right side in Fig. 4). Each mounting portion 8, 12 comprises, respectively: The corresponding female head pin socket 9, the protrusion guidance 10, and the tongue and groove section 11. The first and second mounting portions 8, 12 are mirror-symmetrical to each other about a middle plane of the controller system module 1, which cuts the controller system module 1 in a left half and a right half. When the controller system module 1 is attached to the rail 2, the middle plane is perpendicular to the rail 2. The first and second mounting portions 8, 12 of the same controller system module 1 may be symmetrical about the middle plane of said controller system module 1, whereas the first and second mounting portions 8, 12 are asymmetrical about a plane that is perpendicular to the middle plane parallel to a longitudinal direction of the rail 2. The controller system module 1 further comprises several cable terminals 7 on two opposing sides, namely on an upper side and on a bottom side in Fig. 4.

Fig. 5 depicts the first mounting portion 8 in more detail. The first mounting portion 8 comprises the protrusion guidance 10 and the tongue and groove section 11, which interact with corresponding features of the connectors 3, 4. Further, the controller system module 1 comprises the catch feature to catch a snap-in member of the connector 3, 4 . The catch feature includes or is formed as an indentation 13, in which the snap-in member can be caught, such that the connector 3, 4 is detachably retained. The tongue and groove section 11 comprises a tapered geometry.

If the connector 3, 4 is inserted into the mounting portion 8, the connector 3, 4 is reliably guided to a predetermined final position.

The protrusion guidance 10 may include a hole in a printed circuit board of the controller system module 1. The corresponding lance protrusion 14 may protrude far enough that a portion of the lance protrusion 14 extends through the hole in the printed circuit board if the connector 3 is in the predetermined final position.

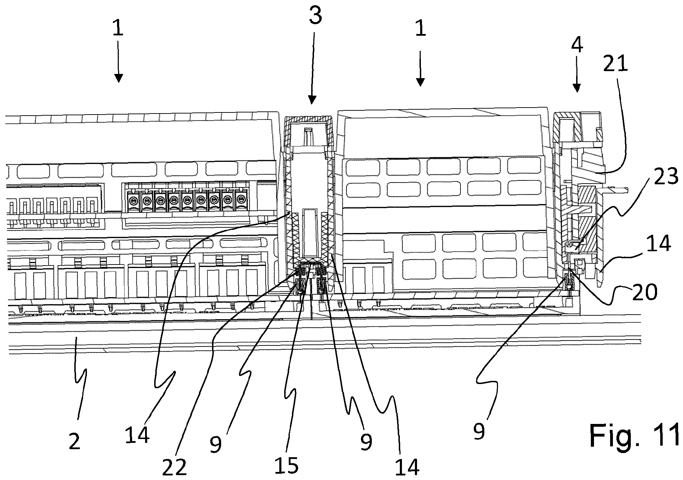

Assuming a case that two of the controller system modules 1 (a first one and a second one) are mounted side by side on the rail 2 as shown in Fig. 4 and Fig. 11, the mounting portion 8 of the first one is located at an end portion of the first one facing the second controller system module 1. Vice versa, the second mounting portion 12 of the second controller system module 1 is located at an end portion of the second one that faces the first one. Said two mounting portions 8, 12 are then located directly adjacent to each other and commonly form a receiving portion for receiving (together) one single middle connector 3. By inserting the middle connector 3 in the receiving portion, the two adjacent controller system modules 1 are directly mechanically and electrically connected by the middle connector 3. As the middle connector 3 is releasable, the mechanical and electrical connection is releasable as well. Establishing the connection is very easy and the connection is reliable. The connection uses space that would not be used efficiently otherwise.

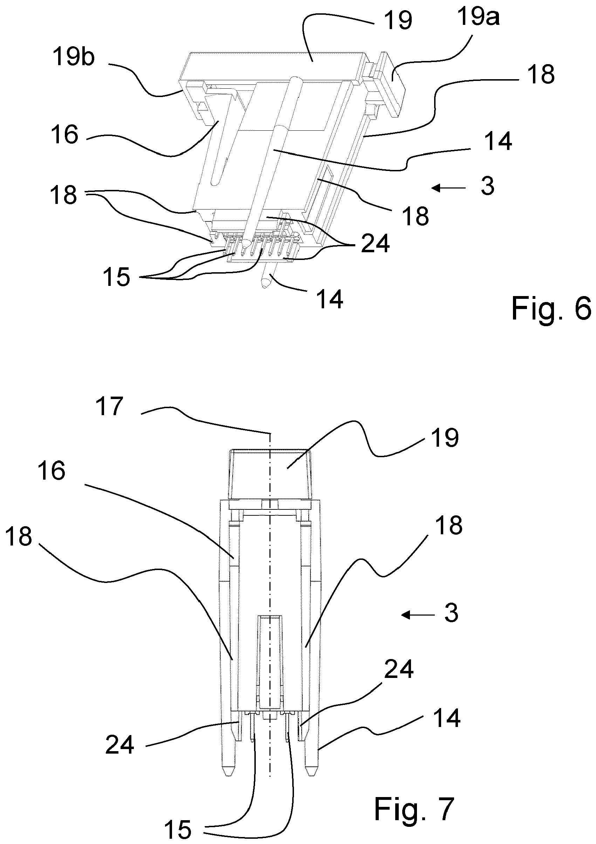

Fig. 6 provides a perspective view, which shows the connector 3 having mechanical pin protrusions 14 (also referred to as lance protrusions 14 in the following) extending over (contact) pins 15. In other words, the lancet pins 14 protrude farther than the (contact) pins 15. The (contact) pins 15 can be formed in a U-shape, such that two opposing pins 15 are actually two ends of one U-shaped pin 15. The connector 3 comprises a resilient snap-in member (resilient member 16), which is bendable under pressure, but comes back into its original state if no pressure is applied. The resilient member 16 comprises two elements (locking features 16a) which are displaced if the resilient member 16 is deformed. In an installed state, each of the two elements is arranged in one of the catch features, respectively indentations 13. The pins 15 are moveable to a certain extent with respect to the housing of the connector 3. By this, misalignments between the female head pin sockets 9 connector 3 can be compensated. Such misalignments can result from various tolerances.

The connector 3 comprises a top section 19, which is actuatable by a user, wherein an actuation of the top section 19 results in a deflection of the resilient member 16. The actuation is performed by pressing a first end side 19a of the top section 19 and a second end side 19b of the top section 19, which is opposite to the first end side 19a, towards each other. For example, a user can place one finger on the first end side 19a and another finger (especially of the same hand) on the second end side 19b and press the fingers in a direction towards each other. The first end side 19a and the second end side 19b may be end sides of the top section 19 in a direction that is perpendicular to the insertion direction and parallel to the central plane 17.

As provided in Fig. 7, the middle connector 3 is mirror-symmetric about a central plane 17 (dotted line). As noted above, the contacts pins 15 are formed in a U-shape, wherein the U opens towards the bottom of the figure.

Two protection plates 24 for protecting the contact pins 15 protrude at a side of the connector 3 opposite to the top section 19 (i.e. a side of the connector 3 for facing towards the rail 2 when the controller system modules are mounted on the rail 2 and the connector 3 is mounted in the receiving portion). The protection plates 24 ensure a risk of accidental deformation of contact pins 15 is reduced. The protection plates 24 may protrude farther in the insertion direction than the contact pins 15. The lance protrusions 14 may protrude farther in the insertion direction than the protection plates 24.

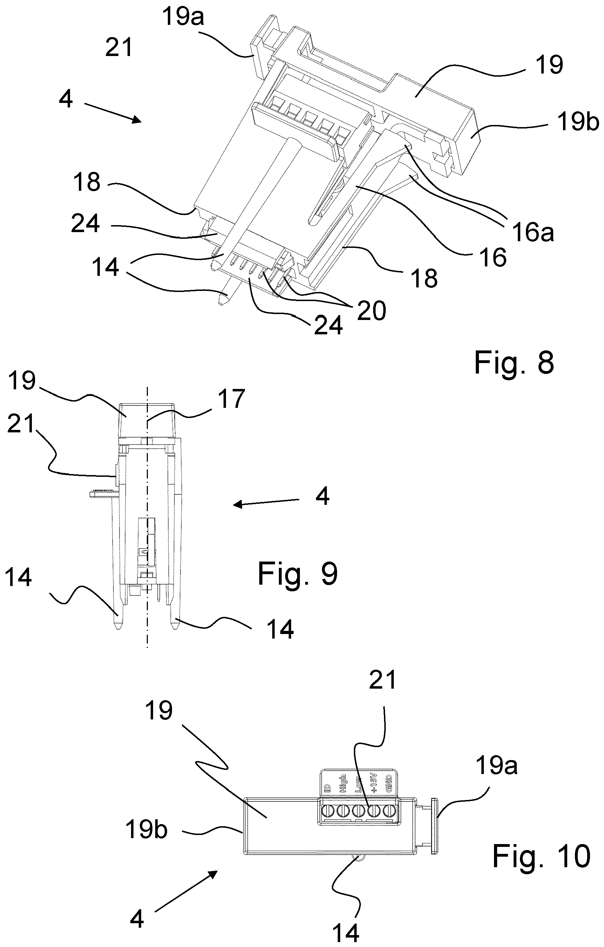

Each lance protrusions 14 interact with the corresponding protrusion guidance 10 of the mounting portions 8, 12. The connector 3 comprises further projections 18, which are configured to interact with the corresponding tongue and groove 11 of the mounting portions 8, 12, at least in a state in which the connector 3 is connected to the first and second controller system module 1. The tapered geometry of the tongue and groove section 11 interacts with the projections 18, such that the controller system modules 1, which are connected via the middle connector 3, are pulled together forming a close connection between the controller system modules 1. Further, the tapered geometry of the tongue and groove section 11 and the corresponding tapered shape of the projections 18 guide the middle connector 3 (and the end connector 4 shown in Fig. 8) into a predetermined final position when inserted into the first mounting portion 8.

The resilient member 16 can be bent towards the projections 18, such that it can overcome the catch feature 13, respectively indentation, of the mounting portions 8, 12.

Fig. 8 to 10 depict the end connector 4, which comprises two lance protrusions 14, the resilient member 16, the projections 18, the end (contact) pins 20, and cable connectors 21 (a cable connector assembly). The lance protrusions 14, the resilient member 16, and the projections 18 are formed equivalent to the ones of the middle connectors 3 described above. The end pins 20 are connected to the cable connectors 21, such that cables (not depicted), which are connected to the cable connectors 21, are in communication with the controller system modules 1 via the end connector 4 if the latter is inserted. The number of end pins 20 may be different from the number of cable connectors 21.

A connector housing of the end connector 4 is similar to the housing of the middle connector 3. Only an area where the cable connectors 21 are located differs. This allows cost-effective production.

The end connector 4 is not symmetrical. The end connector 4 shown in Fig. 8 to 10 is a right end connector 4. The right end connector 4 is adapted to be mounted in the first mounting portion 8. Naturally, the system may alternatively or additionally include a left end connector that is adapted to be mounted in the second mounting portion 12. The left end connector 4 may mirror-inverted with respect to the central plane 17 compared to the right end connector 4.

Similar to the middle connector 3, the end connector 4 comprises a top section 19, which deflects the resilient member 16, when the top section 19 is operated.

The cable connectors 21 have, for example, the following poles: ID, high, low, 14 V and GND (ground). A different pole assignment is also possible. The number of the cable connectors 21 can be different depending on electrical transfer requirements. Further, depending on the electrical transfer requirements, more or less end pins 20 can be provided and connected to cable connectors 21.

Fig. 11 depicts a sectional view in the longitudinal direction of the rail 2, displaying the rail 2, two controller system modules 1, the middle connector 3 and the end connector 4. The lance protrusions 14 of the middle connector 3 protrude into the corresponding protrusion guidances 10 to form a mechanical connection between the connector 3 and the respective controller system modules 1.

The middle connector 3 comprises U-shaped pins 15, which are retained by a pin holder 22. The pin holder 22 allows a certain degree of movement of the pins 15, such that positioning tolerances of female the head pin sockets 9 with respect to the middle connector 3 can be compensated. The pin holder 22 is accommodated in the connector 3, respectively in the connector housing thereof.

The end connector 4 comprises the end (contact) pins 20, which are retained by an end pin holder 23. Each of the end pins 20 is connected to one of the provided cable connectors 21, such that the end pins 20 can be electronically connected to not depicted cables. The end connector 4 comprises further two pin protrusions 14. One lance protrusion 14 of the end connector 4 protrudes into the corresponding protrusion guidance 10 of the controller system module 1, to which the end connector 4 is mounted. The other lance protrusion 14 of the end connector 4 at the side with the cable connectors 21 hangs free.

The female head pin sockets 9 of each connector 3, 4 are connected to not depicted internal components of the connector 3, 4, e.g. to circuit boards of any kinds, a processor, a power system, and/or the like.

The lance protrusion 14 interacting with the protrusion guidance 10, the projections 18 interacting with the tongue and groove section 11 and the snap-in connection constitute the engagement mechanism.

The middle connector 3 is installed to two controller system modules 1 as follows: Both controller system modules 1 are arranged next to each other on the same rail 2, wherein the controller system modules 1 are brought close together, such that the controller system modules 1 are either touching or distanced by less than 2 millimeters. In a subsequent step, the connector 3 is inserted into the adjacently arranged mounting portions 8, 12 of the two controller system modules 1. The connector 3 is inserted, e.g. pushed in the receiving portion, along an insertion direction. The insertion direction is oriented from the top side of the controller system module 1 towards the rail 2. The insertion direction is perpendicular to the rail 2. The connector 3 interacts during the insertion process substantially simultaneously with both controller system modules 1. There is no noticeable delay between mounting the connector 3 to one of both controller system modules 1 and to the other one. The lance protrusions 14 interact with the protrusion guidances 10 and the projections 18 interact with the tongue and groove sections 11. During the insertion process, the resilient member 16 of the connector 3 is deflected, such that the locking features 16a provided on the resilient member 16 are caught in the catch features, respectively the indentations 13 of the controller system modules 1. The U-shaped pins 15 are introduced into the female head pin sockets 9 of the adjacent controller system modules 1 and connect these female head pin sockets 9 (and hence the adjacent controller system modules 1) in an electrical manner. The connection may allow data transfer and/or transfer of electrical power. The middle connector 3 is retained by the snap-in connection in the predetermined final position.

In order to remove the middle connector 3 from its predetermined final position (a connecting position), the resilient member 16 is deflected such that the snap-in connection is disengaged. The resilient member 16 can be deflected toolless, wherein the top portion 19 of the connector 3 is actuated, into a disengaged state. In this embodiment, the locking features 16a are withdrawn out of the indentations 13. Subsequently, the middle connector 3 can be removed by pulling in an opposite direction of the insertion direction, away from the controller system modules 1.

To mount the end connector 4 onto a side of the controller system module 1, wherein on this side no further controller system module 1 is provided, the lance protrusion 14, which is on a side opposite to the cable connector 21, is arranged to interact with the protrusion guidance 10, while the projections 18 of the same side interact with the tongue and groove section 11. During the mounting process, the resilient member is deflected such that the end connector 4 can be pushed to its mounting position (its predetermined final position). At a certain point, the deflection of the resilient member 16 snaps back, such that the locking feature 16a on the side opposite to the cable connectors 21 is caught in the catch feature, respectively the corresponding indentation 13. Cables can be connected to the cable connector 21 before mounting the end connector 4 to the controller system module 1 or afterwards.

Removing the end connector 4 is performed in accordance to the removal of the middle connector 3, described above.

### List of reference signs:

- 1: controller system module
- 2: rail
- 3: middle connector
- 4: end connector
- 5: top unit
- 6: button
- 7: cable terminal
- 8: first mounting portion
- 9: head pin socket
- 10: protrusion guidance
- 11: tongue and groove section
- 12: second mounting portion
- 13: indentation
- 14: lance protrusion
- 15: U-shaped pin
- 16: resilient member
- 16a: locking feature
- 17: central direction
- 18: projection
- 19: top section
- 19a: first end side
- 19b: second end side
- 20: end pins
- 21: cable connectors
- 22: pin holder
- 23: end pin holder
- 24: protection blade

## Claims

1. System for electrically connecting two controller system modules (1) that are mounted side by side on a rail for holding controller system modules,
wherein the system includes a connector (3) having a connector housing, a first mounting portion (8) for receiving a first portion of the connector housing, and a second mounting portion (12) for receiving a second portion of the connector housing,
wherein the first mounting portion (8) is formed on a first module of the two controller system modules (1), at an end portion of the first module (1) facing a second module (1) of the two controller system modules (1),
wherein the second mounting portion (9) is formed on an end portion of the second module facing the first module (1),
wherein the system comprises an engagement mechanism for releasably mechanically fixing the connector (3) to the first module and to the second module (1) when the first portion is received in the first mounting portion (8) and the second portion is received in the second mounting portion (12), and
wherein the system includes electrical connection mechanism for electrically connecting the first module (1) with the second module (1) via the connector (3) when the connector (3) is inserted in the first mounting portion (8) and the second mounting portion (12).

2. The system according to claim 1, **characterized in that** the engagement mechanism includes a snap connection.

3. The system according to claim 2, **characterized in that** the snap connection comprises a resilient snap-in member (16) on the connector housing.

4. The system according to claim 3, **characterized in that** the first module (1) and the second module (1) include catch features (13) for catching the snap-in member (16) when the first portion is received in the first mounting portion (8) and the second portion is received in the second mounting portion (12).

5. The system according to any one of claims 1 to 4, wherein the first mounting portion (8) and the second mounting portion (12) are mirror-symmetric to each other, wherein the connector (3) exhibits a corresponding mirror-symmetry with regard to a central plane (17).

6. The system according to any one of claims 1 to 5, wherein the system is configured to exhibit a mechanical poka-yoke functionality ensuring that the connector (3) can be installed to the first module and second module only in one single predetermined final position and spatial orientation.

7. The system according to any one of claims 1 to 6, wherein the electrical connection mechanism comprises a first female head pin socket (9) at the first module (1) and a second female head pin socket (9) at the second module (1), wherein the connector (3) comprises a U-shaped pin assembly (15) for connecting the first female head pin socket (9) with the second female head pin socket (9).

8. The system according to claim 7, wherein the connector (3) is configured to allow limited movement of the U-shaped pin assembly (15) relative to the connector housing.

9. Method for using a system according to any one of claims 1 to 8, wherein the connector (3) is inserted into the first mounting portion (8) of the first module (1) and into the second mounting portion (12) of the second module (1).

10. Method according to claim 9, wherein the connector (3) is inserted into the first and second mounting portion (8,12) of the first and second module (1) substantially simultaneous.

11. Method according to claim 9 or 10, wherein the connector (3) is installed single handed.

12. Method according to any one of claims 9 to 11, wherein the connector (3) is inserted in an insertion direction, which is in a direction perpendicular to the rail (2), from a top side of the controller system module (1) towards the rail (2), wherein the top side is facing away from the rail (2).

13. Controller system module (2) for a system according to any one of the claims 1 to 8,
wherein the controller system module (1) comprises at least one of the first mounting portion (8) and the second mounting portion (12) and a corresponding electrical interconnection terminal (9) for connection with an electrically conducting assembly (15) of the connector (3) when the connector (3) is mounted to the controller system module (2).

14. Connector (3) for a system according to any one of the claims 1 to 8 with a first electrical interconnection terminal (9) formed at the first module (1) and a second electrical interconnection terminal (9) formed at the second module (2), wherein the connector (3) comprises an electrically conducting assembly (15) for connecting the first electrical interconnection terminal (9) with the second electrical interconnection terminal (9) when the connector (3) is mounted to the first module (1) and the second module (2).

15. End connector (4) for a system according to any one of the claims 1 to 8 wherein, at least at one of the first mounting portion (8) and the second mounting portion (12), an electrical interconnection terminal (9) is formed on the corresponding controller system module (2),
wherein the end connector (4) is adapted to be releasably mounted to the one of the first mounting portion (8) and the second mounting portion (12),
wherein the end connector (4) comprises a cable connector assembly (21) for connecting at least one cable thereto and an electrically conducting assembly (20) for connecting the electrical interconnection terminal (9) at the one of the first mounting portion (8) and the second mounting portion (12) with the cable connector assembly (21) when the end connector (4) is mounted to the one of the first mounting portion (8) and the second mounting portion (12).
